# EUROPEAN PATENT APPLICATION

(11) **EP 4 576 456 A1**
(43) Date of publication of application: **25.06.2025**
(21) Application number: 24219867.9
(22) Date of filing: 13.12.2024
(51) Int. Cl.: H01S 5/14, H01S 5/06, H01S 5/10

(54) **TUNABLE REFLECTOR FOR A SILICON PHOTONIC LASER**

(30) Priority: 15.12.2023 US 202363611008 P
(71) Applicant: Marvell Asia Pte Ltd, Singapore 369522 (SG)
(72) Inventor: HE, Xiaoguang, Diamond Bar, 91765 (US); KATO, Masaki, Palo Alto, 94303 (US); NAGARAJAN, Radhakrishnan, 369522 Singapore (SG); TAYLOR, Brian Dean, Laguna Niguel, 92677 (US)
(74) Representative: Grünecker Patent- und Rechtsanwälte PartG mbB

(57) **Abstract**

An optoelectronic device includes an optical gain medium having a first end and a second end and configured to amplify laser radiation within a gain band, a laser cavity containing the optical gain medium and including a first reflector disposed at the first end of the optical gain medium and a second reflector disposed at the second end of the gain medium and including an interferometer having a tunable reflectance band. The optoelectronic device further includes a controller configured to tune the reflectance band of the interferometer so as to modify a spectrum of the laser radiation emitted from the gain medium through the first reflector.

## Description

### CROSS-REFERENCE TO RELATED APPLICATION

This application claims the benefit of U.S. Provisional Patent Application 63/611,008, filed December 15, 2023, which is incorporated herein by reference.

### FIELD OF THE INVENTION

The present invention relates generally to optoelectronic devices, and particularly to semiconductor lasers.

### BACKGROUND

Wavelength domain multiplexing (WDM) is used in high-speed optical communications to enable multiple communication signals with different carrier wavelengths to be transmitted over the same optical fiber. Some WDM devices use a single laser, emitting radiation at a comb of wavelengths, to provide carrier waves at multiple wavelengths simultaneously. The term "comb," as used in the present description and in the claims, refers to a set of distinct spectral lines, which are spaced apart by equal steps in wavelength. The term "comb filter" refers to an optical filter having a passband consisting of such a comb, such that the comb filter passes light having a wavelength in the set of distinct spectral lines while blocking wavelengths between the lines in the set.

Other laser applications use a laser emitting radiation at a single wavelength, employing a bandpass filter. In some applications, a tunable bandpass filter may be employed to tune the wavelength of the laser radiation.

The terms "light" and "optical radiation" are used synonymously in the present description and in the claims to refer to electromagnetic radiation in any of the infrared, visible, and ultraviolet spectral ranges.

Mach-Zehnder interferometers (MZIs) are used in a variety of silicon photonics applications. For example, El Shamy et al. describe a tunable filter based on an MZI in "Modelling, characterization, and applications of silicon on insulator loop terminated asymmetric Mach Zehnder interferometer," Scientific Reports 12:3598

(2022). The authors describe a loop-terminated MZI whose spectrum can be tuned not only by controlling the phase difference between the interferometer arms, but also by using its directional couplers coefficients, forming a spectral tunable filter.

As another example, U.S. Patent 11,575,245 describes a wavelength-tunable semiconductor laser. The device includes a cavity between a high-reflectivity facet and an anti-reflection facet designed to emit a laser light of a wavelength in a tunable range determined by two Vernier-ring resonators. A waveguide-based delay-line interferometer is used to lock the wavelength of the reflected light from a tunable filter.

### SUMMARY

Embodiments of the present invention that are described hereinbelow provide improved designs for tunable lasers.

There is therefore provided, in accordance with an embodiment described herein, an optoelectronic device. The optoelectronic device includes an optical gain medium having a first end and a second end and configured to amplify laser radiation within a gain band. The optoelectronic device further includes a laser cavity containing the optical gain medium and including a first reflector disposed at the first end of the optical gain medium and a second reflector disposed at the second end of the gain medium and including an interferometer having a tunable reflectance band. The optoelectronic device also includes a controller configured to tune the reflectance band of the interferometer so as to modify a spectrum of the laser radiation emitted from the gain medium through the first reflector.

In a disclosed embodiment, the device includes a filter disposed within the laser cavity and configured to pass a set of distinct wavelength sub-bands within the gain band, wherein the controller is configured to select one or more of the wavelength sub-bands for emission through the first reflector by tuning the reflectance band of the interferometer.

In a further embodiment, the filter includes one or more optical ring resonators.

In one embodiment, the set of distinct wavelength sub-bands defines a comb, and the controller is configured to select a subset of the wavelength sub-bands in the comb for emission through the first reflector by tuning the reflectance band of the second reflector.

In a further embodiment, the interferometer includes a tunable Mach-Zehnder interferometer (MZI).

In an additional embodiment, the tunable MZI includes a pair of waveguides with respective first and second ends and disposed on a substrate, wherein the respective first ends are coupled with a first directional coupler and the respective second ends are coupled with a second directional coupler.

In yet another embodiment, the controller is configured to tune the reflectance band of the MZI by varying an optical path length difference between the pair of waveguides.

In a further embodiment, the controller is configured to tune a center wavelength of the reflectance band of the MZI by varying the optical path length difference between the pair of waveguides.

In another embodiment, the controller is configured to tune a spectral bandwidth of the reflectance band of the MZI by varying the optical path length difference between the pair of waveguides.

In yet another embodiment, the controller is configured to tune an amplitude of the reflectance band by varying an optical coupling coefficient of at least one of the first and second directional couplers.

In one embodiment, the device includes at least one heater disposed in proximity to the interferometer, wherein the controller is coupled to control the at least one heater so as to tune the reflectance band of the interferometer.

In a further embodiment, the gain medium and the first reflector are together included in a reflective semiconductor optical amplifier (RSOA), and the second reflector is included in an external laser cavity, which is disposed on an optical substrate and is optically coupled to the RSOA.

In a yet further embodiment, the RSOA includes a III-V semiconductor material, and the external laser cavity includes a silicon photonic integrated circuit (PIC) .

There is also provided, in accordance with an embodiment described herein, a method for generating radiation. The method includes providing an optical gain medium having first and second ends and configured to amplify laser radiation within a gain band. The gain medium is inserted in a laser cavity including a first reflector disposed on the first end of the gain medium and a second reflector including an interferometer having a tunable reflectance band disposed at the second end of the gain medium. The reflectance band of the second reflector is tuned so as to modify a spectrum of the laser radiation emitted from the gain medium through the first reflector.

The present invention will be more fully understood from the following detailed description of the embodiments thereof, taken together with the drawings in which:

### BRIEF DESCRIPTION OF THE DRAWINGS

Fig. 1 is a block diagram that schematically illustrates a tunable laser device, in accordance with an embodiment of the invention;
Fig. 2A is a plot that schematically shows spectral characteristics of components of the device of Fig. 1, in accordance with an embodiment described herein;
Fig. 2B is a plot that schematically shows the spectral output of the device of Fig. 1, in accordance with an embodiment described herein;
Fig. 3 is a schematic detail view of a tunable reflector, in accordance with an embodiment of the invention;
Fig. 4 is a graph that schematically shows variation of the width of the reflectance band of the tunable reflector of Fig. 3 in response to a waveguide length difference, in accordance with an embodiment described herein;
Fig. 5 is a graph that schematically shows the shift of the center wavelength of the reflectance band of the tunable reflector of Fig. 3 in response to a waveguide length difference, in accordance with an embodiment described herein;
Figs. 6A, 6B, 6C and 6D are graphs that schematically show variations in the reflectance band of the tunable reflector of Fig. 3 in response to changes in a coupling coefficient, in accordance with an embodiment described herein;
Fig. 7 is a block diagram that schematically illustrates a tunable comb laser device, in accordance with an embodiment of the invention;
Fig. 8A is a plot that schematically shows spectral characteristics of components of the device of Fig. 7, in accordance with an embodiment described herein;
Fig. 8B is a plot that schematically shows the spectral output of the device of Fig. 7, in accordance with an embodiment described herein; and
Fig. 9 is a flowchart that schematically illustrates a method for generating radiation, in accordance with an embodiment described herein.

### DETAILED DESCRIPTION OF EMBODIMENTS

Some semiconductor lasers emit either a comb of wavelength sub-bands extending over a certain spectral range or a single, possibly tunable, wavelength. These lasers typically comprise a gain medium contained in a laser cavity, comprising reflectors on opposing sides of the gain medium, along with a suitable filter within or outside the laser cavity. One of the reflectors is typically a high-reflectance reflector with a reflectance close to unity within the bandwidth of the laser, whereas the other reflector, a so-called output reflector, has a lower reflectance so as to transmit some of the light propagating in the laser cavity as an output beam of the laser.

In embodiments of the present invention, the high-reflectance reflector of the laser cavity containing the gain medium has a spectral reflectance band (i.e., varying reflectance as a function of wavelength) that is relatively narrow and tunable, while the output reflector passes a wider range of wavelengths. Specifically, the high-reflectance reflector comprises an interferometer, such as a tunable MZI, whose reflectance band can be controlled by modifying the optical path length difference or coupling coefficient between the arms of the interferometer. Such an interferometer can be readily implemented by forming suitable waveguides on a substrate using silicon photonics technology. A termination loop is utilized as a high-reflectance mirror at one end of the interferometer. In some embodiments, the laser cavity comprises an additional filter, such as a comb filter or a bandpass filter.

Tuning of the interferometer causes the gain medium to lase only on lines within the reflectance band of the high-reflectance reflector. Wavelengths outside this band are suppressed due to the low reflectance of the combination of interferometer with the termination loop at these wavelengths. The present embodiments thus provide efficient laser devices, with spectral output that can be flexibly and precisely controlled.

The disclosed embodiments thus provide optoelectronic devices comprising an optical gain medium within a laser cavity. The gain medium is configured to amplify laser radiation within a gain band. The laser cavity comprises a first reflector disposed at a first end of the optical gain medium and a second reflector, comprising an interferometer having a tunable reflectance band, disposed at a second end of the gain medium. A controller tunes the reflectance band of the interferometer so as to modify the spectrum of the laser radiation emitted from the gain medium through the first reflector.

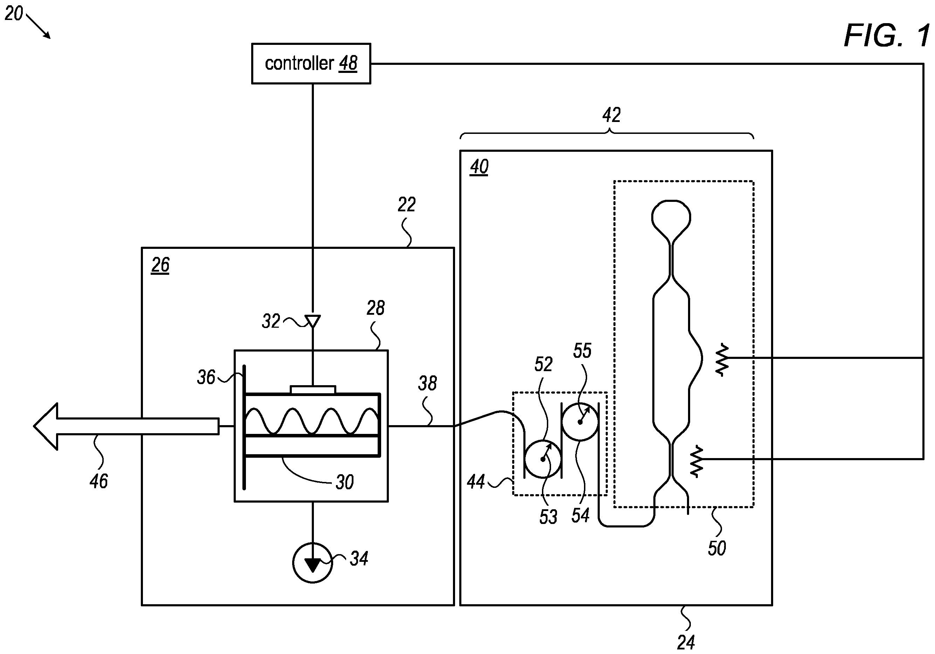

Fig. 1 is a block diagram that schematically illustrates a tunable single-wavelength laser device 20, in accordance with an embodiment of the invention. Device 20 comprises an active optical chip 22 on a III-V semiconductor substrate 26, such as GaAs or InP, and a PIC 24 on an optical substrate 40, for example a silicon-on-insulator (SOI) substrate. For mechanical stability and compact packaging, chip 22 may be bonded to optical substrate 40, for example using a suitable adhesive. Alternatively, chip 22 and PIC 24 may be mounted separately and connected, for example, by a suitable optical fiber.

Chip 22 comprises a reflective semiconductor optical amplifier (RSOA) 28, comprising an optical gain medium 30, which amplifies laser radiation within a certain gain band, and a reflector 36 formed at the outer end of gain medium 30. The reflectance of reflector 36 is less than unity so as to serve as the output reflector for the laser radiation that is amplified by gain medium 30. A controller 48 applies a drive voltage between electrodes 32 and 34 on chip 22, giving rise to optical gain in medium 30 across the gain band. The gain band may extend, for example, over a band of several tens of nanometers centered at a peak at around 1310 nm or 1550 nm depending on the type of gain medium that is used. Gain medium 30 may comprise, for example, GaInAsP, AlGaInAs quantum wells, or InAs quantum dots, which emit light in these gain bands. Reflector 36 may comprise a distributed Bragg reflector (DBR), for example, or a reflective coating on the rear facet of the RSOA. A waveguide 38 on substrate 26 conveys laser radiation into and out of the RSOA at the end opposite reflector 36.

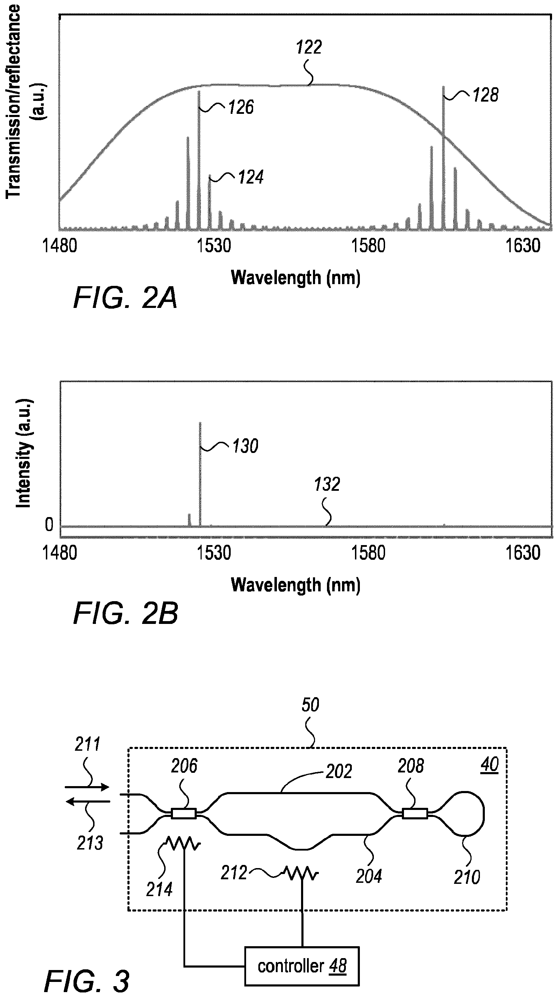

PIC 24 comprises an external laser cavity 42, which is optically coupled to waveguide 38 and terminates in a tunable reflector 50. Reflector 50 comprises an interferometer, which is highly reflecting and has a reflectance as a function of wavelength that is tunable, as further detailed in Fig. 3 hereinbelow.

Laser device 20 emits laser radiation through reflector 36, as shown by an arrow 46.

Cavity 42 contains a filter 44 comprising two ring resonators 52 and 54 coupled in series, with respective radii indicated by arrows 53 and 55. The radii are chosen so that each ring resonator has a ring length that passes a respective comb of wavelength sub-bands. The beating of the two combs of ring resonators 52 and 54 produces discrete transmission peaks, which, in combination with the trapezoidal reflectance band of reflector 50, are utilized to select a single wavelength within the trapezoidal reflectance band, as further detailed in Figs. 2A and 2B hereinbelow.

Fig. 2A is a plot that schematically shows spectral characteristics of components of device 20 of Fig. 1, in accordance with an embodiment described herein. A curve 122 depicts the reflectance of reflector 50. The reflectance has a trapezoidal form, centered at a wavelength of 1555 nm and with a high value (approaching unity) from 1530 nm to 1580 nm. Beyond these wavelengths, the reflectance decays to lower values. A curve 124 depicts the transmission of filter 44. The specific shape of curve 124 is due to the beat frequencies of the two ring resonators 52 and 54. Curve 124 has two high peaks 126 and 128. This sort of use of serially coupled ring resonators (Vernier-ring resonators) is described in the above-referenced U.S. Patent 11,575,245.

Fig. 2B is a plot that schematically shows the spectral output of device 20 of Fig. 1, in accordance with an embodiment described herein. Peak 126 in Fig. 2A combines with the high reflectance value of reflector 50 (curve 122) to enable lasing of laser device 20, shown by a peak 130 in a curve 132 depicting the laser output. Peak 128, however, is located at a lower reflectance of reflector 50, and thus lasing is suppressed at this wavelength.

Fig. 3 is a schematic detail view of tunable reflector 50, in accordance with an embodiment of the invention. In this embodiment, reflector 50 comprises a thermally tunable MZI, comprising a pair of waveguides 202, 204 on substrate 40. Waveguides 202 and 204 are coupled together at both their ends by directional couplers 206 and 208, and a termination loop 210 is coupled to directional coupler 208. An optical wave entering reflector 50, as shown by an arrow 211, is split by directional coupler 206 into waveguides 202 and 204, with the split determined by a coupling coefficient κ22 of coupler 206. The optical waves propagating in the two waveguides are again recombined by directional coupler 208 with a coupling coefficient κ12, interfering with each other. The amplitude of the resulting total optical wave is determined by the coupling coefficients and the optical path lengths along the two waveguides 202 and 204. Thus, the two waveguides 202 and 204, together with directional couplers 206 and 208, form an interferometer, with this specific type called a Mach-Zehnder interferometer. The optical wave exiting from the interferometer via directional coupler 208 enters loop 210, which returns the wave back into the interferometer.

The respective coupling coefficients κ22 and κ12 of directional couplers 206 and 208 depend on the geometrical properties and effective refractive indices of the couplers. These coupling coefficients determine the relative amounts of laser energy that are split between waveguides 202 and 204 and thus set the base reflectance of reflector 50 (for example as described in the above-mentioned article by El Shamy et al.) Waveguide 202 is coupled to cavity 42, for example to filter 44 of Fig. 1, as shown by arrows 211 and 213.

Controller 48 tunes the reflectance band of reflector 50 by applying electrical currents to a resistive heater 212 in close proximity to waveguide 204 and/or a resistive heater 214 in close proximity to directional coupler 206. Both resistive heaters comprise resistive traces on substrate 40. (In other embodiments, additional resistive heaters can be located in close proximity to waveguide 202 and/or to directional coupler 208.)

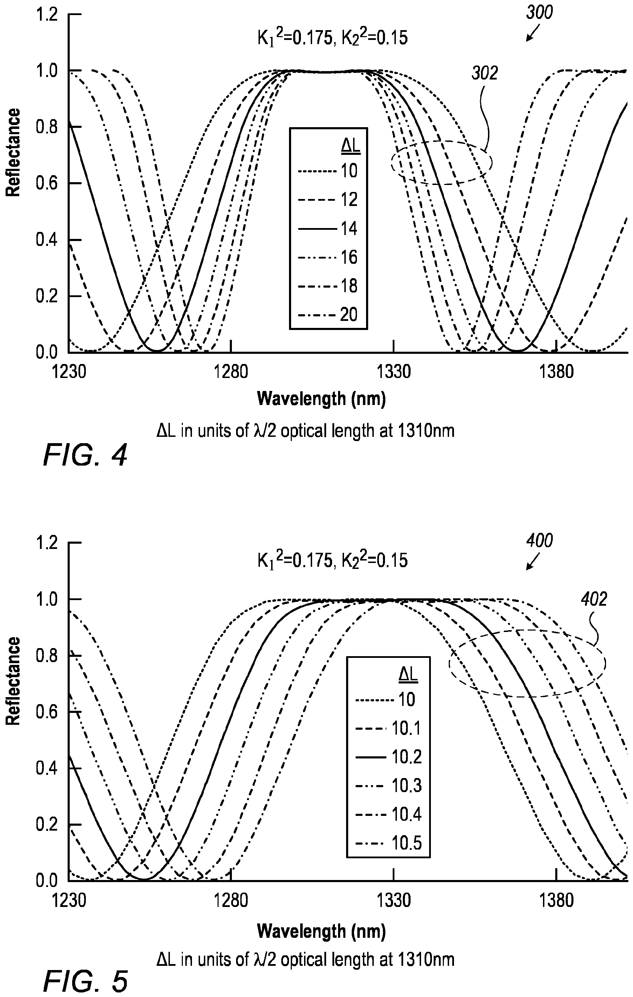

To control the bandwidth and central wavelength of the reflectance band of reflector 50, controller 48 applies an electrical current to heater 212. The temperature differential between waveguides 202 and 204 results in a difference ΔL in the effective optical lengths of the waveguides, which in turn tunes the phase difference between the optical waves that meet at directional couplers 206 and 208. This phase difference, which varies as a function of wavelength, controls the spectral bandwidth and central wavelength of the spectral reflectance of reflector 50, as will be further detailed in Figs. 4 and 5 hereinbelow.

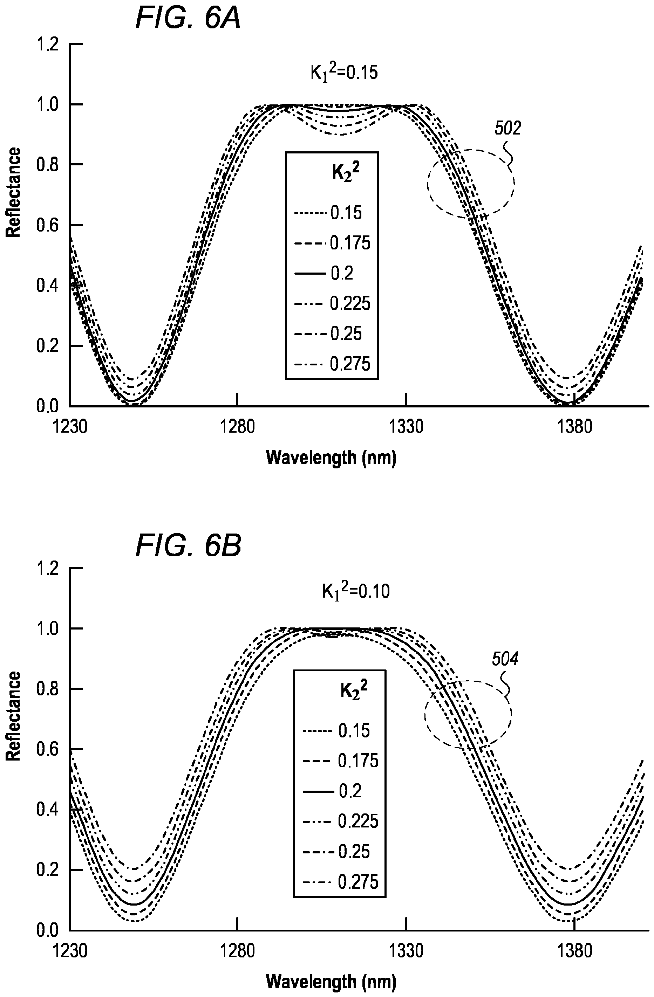

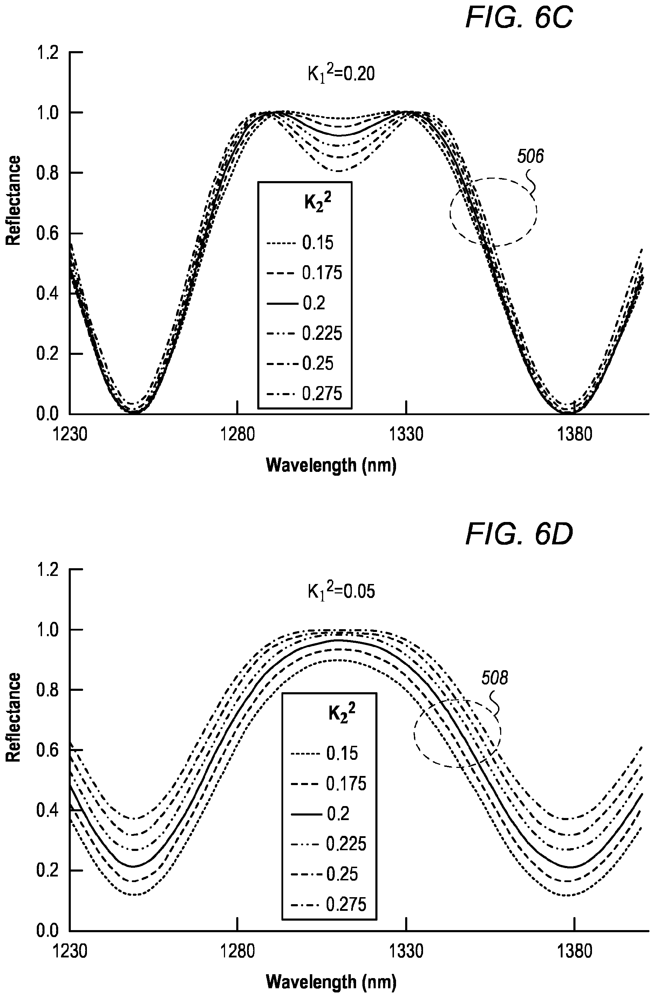

To control the peak reflectance of reflector 50, controller 48 applies an electrical current to heater 214 adjacent to directional coupler 206. The heating of substrate 40 and waveguides 202 and 204 at directional coupler 206 results in a change in the coupling coefficient κ22 of the directional coupler, which controls the interaction between the guided waves propagating in the two waveguides. The resulting change in the peak reflectance is detailed in Fig. 6 hereinbelow.

In alternative embodiments, other means (not shown in the figures), such as electro-optical modulation, may be used to control the optical path lengths and coupling coefficients. Furthermore, although reflector 50 in the pictured embodiments is based on a tunable MZI, in alternative embodiments (not shown in the figures), reflector 50 may comprise other types of tunable interferometers suitable for the present purposes.

Fig. 4 is a graph 300 that schematically shows curves 302 illustrating the variation of the spectral bandwidth of the reflectance band of reflector 50 as a function of the optical path length difference ΔL, in accordance with an embodiment described herein.

Curves 302 depict the reflectance band of reflector 50 in a spectrum centered at 1310 nm for the following integer values of ΔL in units of half wavelength of 1310 nm: 10, 12, 14, 16, 18 and 20. As previously described in reference to Fig. 3, controller 48 can vary ΔL by means of a heater 212 adjacent to waveguide 204 (and optionally by an additional heater adjacent to waveguide 202). The coupling coefficients of directional couplers 206 and 208 in the example shown in Fig. 4 have values κ22 = 0.15 and κ12 = 0.175, respectively. Curves 302 show that the bandwidth of the reflectance decreases monotonically as ΔL increases.

Fig. 5 is a graph 400 that schematically shows curves 402 illustrating the shift of the center wavelength of the reflectance band of reflector 50 from 1310 nm as a function of the optical path length difference ΔL, in accordance with an embodiment described herein.

Curves 402 depict the reflectance band of reflector 50 for the following non-integer values of ΔL in units of half wavelength of 1310 nm: 10, 10.1, 10.2, 10.3, 10.4 and 10.5, wherein ΔL is controlled as previously described. The coupling coefficients of directional couplers 206 and 208 have values κ22 = 0.15 and κ12 = 0.175, respectively. Curves 402 show that the center wavelength of the reflectance shifts monotonically from 1310 nm toward higher wavelengths as ΔL increases.

Figs. 6A, 6B, 6C and 6D are graphs that schematically show curves 502, 504, 506, and 508 illustrating the amplitude of the reflectance of reflector 50 as a function of κ22, given different values of κ12, in accordance with an embodiment described herein.

Each set of curves 502, 504, 506 and 508 in respective Figs. 6A, 6B, 6C and 6D depicts the reflectance of reflector 50 for the following values of coupling coefficient κ22 of directional coupler 206: 0.15, 0.175, 0.2, 0.225, 0.25 and 0.275. As previously described in reference to Fig. 3, κ22 can be controlled by varying the temperature of heater 214 adjacent to directional coupler 206. Coupling coefficient κ12 of directional coupler 208 has the values 0.15, 0.10, 0.20 and 0.05 for respective curves 502, 504, 506 and 508.

As can be observed in Figs. 6A-6D, varying the values of coupling coefficient κ22 has the most impact on the peak value of the reflectance for κ12 = 0.20 (Fig. 6C) and κ12 = 0.05 (Fig. 6D). In Fig. 6D there is additionally an overall effect of varying the amplitude of the reflectance across the entire bandwidth. Varying the amplitude of reflectance can be useful in matching the loss of mirror 50 to the gain of gain medium 30, for example in order to flatten the amplitude of optical output as a function of wavelength within the desired laser output band while suppressing undesired spectral lines outside the laser output band.

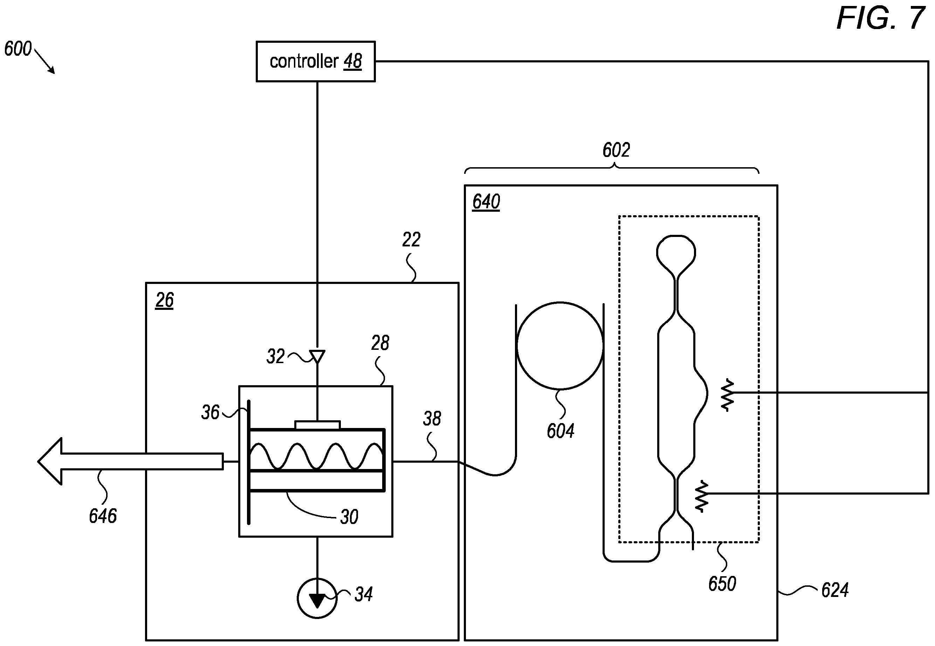

Fig. 7 is a block diagram that schematically illustrates a tunable comb laser device 600, in accordance with another embodiment of the invention.

Optical chip 22 in laser device 600 is identical or similar to optical chip 22 in Fig. 1; its components are labeled with the same reference numbers, and their description is omitted here for the sake of brevity. Laser device 600 emits its optical radiation through reflector 36, as shown by an arrow 646.

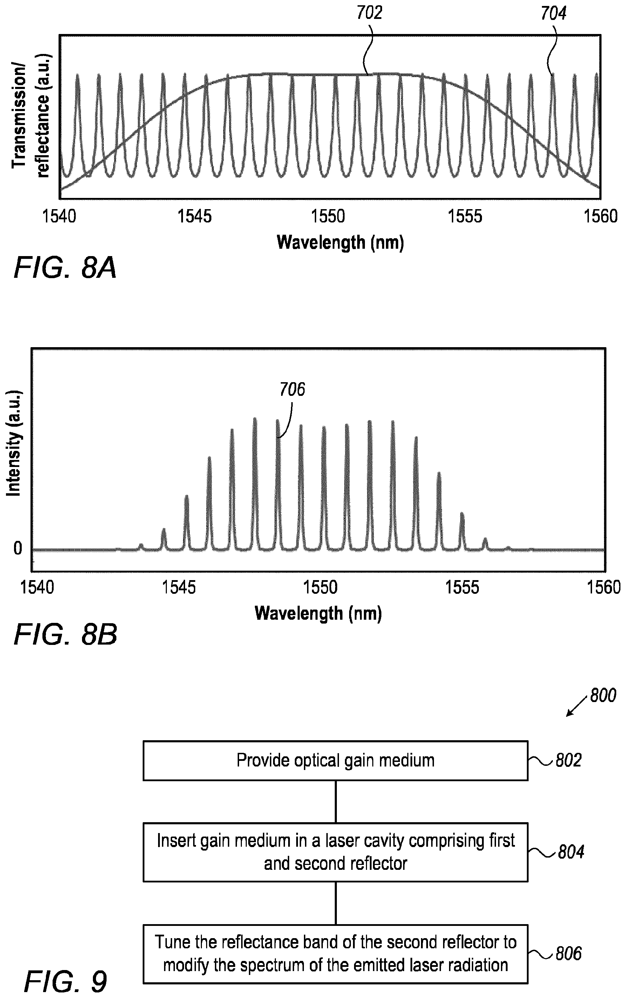

Laser device comprises a PIC 624 comprising an external laser cavity 602, which is optically coupled to waveguide 38 and terminates in a tunable reflector 650, which is identical or similar to tunable reflector 50 detailed in Fig. 3 hereinabove. Cavity 602 contains a ring resonator 604 with a ring length chosen so that the ring resonator functions as a comb filter, passing a comb of wavelength sub-bands. In this example, the comb extends over a broader wavelength band than the passband of tunable reflector 650, as is further detailed in Figs. 8A and 8B hereinbelow.

Controller 48 tunes the reflectance band of tunable filter 650 in a manner similar to that described hereinabove with respect to tunable filter 50.

Fig. 8A is a plot that schematically shows spectral characteristics of components of device 600 of Fig. 7, in accordance with an embodiment described herein. A curve 702 depicts the reflectance of reflector 650. The reflectance is centered at a wavelength of 1550 nm and has a high value (approaching unity) from 1547 nm to 1553 nm. Beyond these wavelengths, the reflectance decays to lower values. A curve 704 depicts the wavelength comb transmitted by ring resonator 604.

Fig. 8B is a plot that schematically shows the spectral output of device 600 of Fig. 7, in accordance with an embodiment described herein. The portion of the wavelength comb coinciding with the high-reflectance band of reflector 650 enables lasing of laser device 600 within this band, shown by a curve 706. The bandwidth of the lasing, i.e., the number of wavelength peaks, together with the center wavelength of the lasing and amplitude of the peaks, can be tuned by tuning reflector 650 as described with reference to Figs. 4-6D hereinabove.

Fig. 9 is a flowchart 800 that schematically depicts a method for generating radiation, in accordance with an embodiment described herein.

In a gain medium step 802, an optical gain medium is provided. The gain medium has first and second ends and it amplifies laser radiation within a gain band. In a laser cavity step 804, the gain medium is inserted in a laser cavity with first and a second reflectors disposed at the respective ends of the gain medium. The second reflector comprises an interferometer having a tunable reflectance band disposed at the second end of the gain medium. In a tuning step 806, the reflectance band of the second reflector is tuned by adjusting the reflectance band of the interferometer so as to modify a spectrum of the laser radiation emitted from the gain medium through the first reflector.

It is noted that the embodiments described above are cited by way of example, and that the present invention is not limited to what has been particularly shown and described hereinabove. Rather, the scope of the present invention includes both combinations and subcombinations of the various features described hereinabove, as well as variations and modifications thereof which would occur to persons skilled in the art upon reading the foregoing description and which are not disclosed in the prior art.

### The following is a list of further preferred embodiments of the invention:

Embodiment 1. An optoelectronic device, comprising:
   an optical gain medium having a first end and a second end and configured to amplify laser radiation within a gain band;
   a laser cavity containing the optical gain medium and comprising:
      a first reflector disposed at the first end of the optical gain medium; and
      a second reflector disposed at the second end of the gain medium and comprising an interferometer having a tunable reflectance band; and
      a controller configured to tune the reflectance band of the interferometer so as to modify a spectrum of the laser radiation emitted from the gain medium through the first reflector.
Embodiment 2. The device according to embodiment 1 and comprising a filter disposed within the laser cavity and configured to pass a set of distinct wavelength sub-bands within the gain band,
   wherein the controller is configured to select one or more of the wavelength sub-bands for emission through the first reflector by tuning the reflectance band of the interferometer.
Embodiment 3. The device according to embodiment 2, wherein the filter comprises one or more optical ring resonators.
Embodiment 4. The device according to embodiment 2, wherein the set of distinct wavelength sub-bands defines a comb, and wherein the controller is configured to select a subset of the wavelength sub-bands in the comb for emission through the first reflector by tuning the reflectance band of the second reflector.
Embodiment 5. The device according to embodiment 1, wherein the interferometer comprises a tunable Mach-Zehnder interferometer (MZI).
Embodiment 6. The device according to embodiment 5, wherein the tunable MZI comprises a pair of waveguides with respective first and second ends and disposed on a substrate, wherein the respective first ends are coupled with a first directional coupler and the respective second ends are coupled with a second directional coupler.
Embodiment 7. The device according to embodiment 6, wherein the controller is configured to tune the reflectance band of the MZI by varying an optical path length difference between the pair of waveguides.
Embodiment 8. The device according to embodiment 7, wherein the controller is configured to tune a center wavelength of the reflectance band of the MZI by varying the optical path length difference between the pair of waveguides.
Embodiment 9. The device according to embodiment 7, wherein the controller is configured to tune a spectral bandwidth of the reflectance band of the MZI by varying the optical path length difference between the pair of waveguides.
Embodiment 10. The device according to embodiment 6, wherein the controller is configured to tune an amplitude of the reflectance band by varying an optical coupling coefficient of at least one of the first and second directional couplers.
Embodiment 11. The device according to embodiment 1 and comprising at least one heater disposed in proximity to the interferometer, wherein the controller is coupled to control the at least one heater so as to tune the reflectance band of the interferometer.
Embodiment 12. The device according to embodiment 1, wherein the gain medium and the first reflector are together comprised in a reflective semiconductor optical amplifier (RSOA), and the second reflector is comprised in an external laser cavity, which is disposed on an optical substrate and is optically coupled to the RSOA.
Embodiment 13. The device according to embodiment 12, wherein the RSOA comprises a III-V semiconductor material, and wherein the external laser cavity comprises a silicon photonic integrated circuit (PIC).
Embodiment 14. A method for generating radiation, the method comprising:
   providing an optical gain medium having first and second ends and configured to amplify laser radiation within a gain band;
   inserting the gain medium in a laser cavity comprising a first reflector disposed on the first end of the gain medium and a second reflector comprising an interferometer having a tunable reflectance band disposed at the second end of the gain medium; and
   tuning the reflectance band of the second reflector so as to modify a spectrum of the laser radiation emitted from the gain medium through the first reflector.
Embodiment 15. The method according to embodiment 14 and comprising inserting within the laser cavity a filter configured to pass a set of distinct wavelength sub-bands within the gain band, and selecting one or more of the wavelength sub-bands for emission through the first reflector by tuning the reflectance band of the second reflector.
Embodiment 16. The method according to embodiment 15, wherein inserting the filter comprises inserting one or more optical ring resonators within the laser cavity.
Embodiment 17. The method according to embodiment 15, wherein the set of distinct wavelength sub-bands defines a comb, and wherein selecting the one or more of the wavelength sub-bands comprises selecting a subset of the wavelength sub-bands in the comb for emission through the first reflector by tuning the reflectance band of the second reflector.
Embodiment 18. The method according to embodiment 14, wherein inserting the gain medium comprises configuring the second reflector as a tunable Mach-Zehnder interferometer (MZI).
Embodiment 19. The method according to embodiment 18, wherein configuring the second reflector comprises providing a pair of waveguides with respective first and second ends on a substrate, coupling the respective first ends with a first directional coupler, and coupling the respective second ends with a second directional coupler.
Embodiment 20. The method according to embodiment 19, wherein tuning the reflectance band of the MZI comprises varying an optical path length difference between the pair of waveguides.
Embodiment 21. The method according to embodiment 19, wherein tuning the reflectance band of the MZI comprises varying an optical coupling coefficient of at least one of the first and second directional couplers.

## Claims

1. An optoelectronic device, comprising:
an optical gain medium having a first end and a second end and configured to amplify laser radiation within a gain band;
a laser cavity containing the optical gain medium and comprising:
a first reflector disposed at the first end of the optical gain medium; and
a second reflector disposed at the second end of the gain medium and comprising an interferometer having a tunable reflectance band; and
a controller configured to tune the reflectance band of the interferometer so as to modify a spectrum of the laser radiation emitted from the gain medium through the first reflector.

2. The device according to claim 1 and comprising a filter disposed within the laser cavity and configured to pass a set of distinct wavelength sub-bands within the gain band,
wherein the controller is configured to select one or more of the wavelength sub-bands for emission through the first reflector by tuning the reflectance band of the interferometer.

3. The device according to claim 2, wherein the filter comprises one or more optical ring resonators.

4. The device according to claim 2, wherein the set of distinct wavelength sub-bands defines a comb, and wherein the controller is configured to select a subset of the wavelength sub-bands in the comb for emission through the first reflector by tuning the reflectance band of the second reflector.

5. The device according to one of claims 1 to 4, wherein the interferometer comprises a tunable Mach-Zehnder interferometer (MZI).

6. The device according to claim 5, wherein the tunable MZI comprises a pair of waveguides with respective first and second ends and disposed on a substrate, wherein the respective first ends are coupled with a first directional coupler and the respective second ends are coupled with a second directional coupler.

7. The device according to claim 6, wherein the controller is configured to tune the reflectance band of the MZI by varying an optical path length difference between the pair of waveguides.

8. The device according to claim 7, wherein the controller is configured to tune a center wavelength of the reflectance band of the MZI by varying the optical path length difference between the pair of waveguides, or
wherein the controller is configured to tune a spectral bandwidth of the reflectance band of the MZI by varying the optical path length difference between the pair of waveguides.

9. The device according to claim 6, wherein the controller is configured to tune an amplitude of the reflectance band by varying an optical coupling coefficient of at least one of the first and second directional couplers.

10. The device according to one of claims 1 to 9 and comprising at least one heater disposed in proximity to the interferometer, wherein the controller is coupled to control the at least one heater so as to tune the reflectance band of the interferometer.

11. The device according to one of claims 1 to 10, wherein the gain medium and the first reflector are together comprised in a reflective semiconductor optical amplifier (RSOA), and the second reflector is comprised in an external laser cavity, which is disposed on an optical substrate and is optically coupled to the RSOA, and/or
wherein the RSOA comprises a III-V semiconductor material, and wherein the external laser cavity comprises a silicon photonic integrated circuit (PIC).

12. A method for generating radiation, the method comprising:
providing an optical gain medium having first and second ends and configured to amplify laser radiation within a gain band;
inserting the gain medium in a laser cavity comprising a first reflector disposed on the first end of the gain medium and a second reflector comprising an interferometer having a tunable reflectance band disposed at the second end of the gain medium; and
tuning the reflectance band of the second reflector so as to modify a spectrum of the laser radiation emitted from the gain medium through the first reflector.

13. The method according to claim 12 and comprising inserting within the laser cavity a filter configured to pass a set of distinct wavelength sub-bands within the gain band, and selecting one or more of the wavelength sub-bands for emission through the first reflector by tuning the reflectance band of the second reflector, and/or
wherein inserting the filter comprises inserting one or more optical ring resonators within the laser cavity.

14. The method according to claim 13, wherein the set of distinct wavelength sub-bands defines a comb, and wherein selecting the one or more of the wavelength sub-bands comprises selecting a subset of the wavelength sub-bands in the comb for emission through the first reflector by tuning the reflectance band of the second reflector.

15. The method according to one of claims 12 to 14, wherein inserting the gain medium comprises configuring the second reflector as a tunable Mach-Zehnder interferometer (MZI), and/or
wherein configuring the second reflector comprises providing a pair of waveguides with respective first and second ends on a substrate, coupling the respective first ends with a first directional coupler, and coupling the respective second ends with a second directional coupler, and/or
wherein tuning the reflectance band of the MZI comprises varying an optical path length difference between the pair of waveguides, or
wherein tuning the reflectance band of the MZI comprises varying an optical coupling coefficient of at least one of the first and second directional couplers.
